# EUROPEAN PATENT APPLICATION

(11) **EP 4 645 431 A2**
(43) Date of publication of application: **05.11.2025**
(21) Application number: 25169242.2
(22) Date of filing: 08.04.2025
(51) Int. Cl.: H01M 4/131, H01M 4/36, H01M 4/525, H01M 4/58, C01G 53/00, H01M 4/62

(54) **POSITIVE ELECTRODE FOR RECHARGEABLE LITHIUM BATTERY, AND RECHARGEABLE LITHIUM BATTERY INCLUDING THE SAME**

(30) Priority: 29.04.2024 KR 20240056957
(71) Applicant: SAMSUNG SDI CO., LTD., Yongin-si, Gyeonggi-do 17084 (KR)
(72) Inventor: KANG, Gwiwoon, 17084 Yongin-si (KR); LEE, Soonrewl, 17084 Yongin-si (KR); KIM, Young-Ki, 17084 Yongin-si (KR); CHOI, Aram, 17084 Yongin-si (KR); KIM, Sangmi, 17084 Yongin-si (KR); DOO, Sungwook, 17084 Yongin-si (KR)
(74) Representative: Marks & Clerk LLP

(57) **Abstract**

A rechargeable lithium battery including a positive electrode, the positive electrode including a current collector, a first active material layer on the current collector, and a second active material layer on the first active material layer, wherein the first active material layer and the second active material layer each include a first particle, and the second active material layer further includes a second particle. The first particle is an olivine-based particle, and the second particle is a layered particle.

## Description

### BACKGROUND

### 1. Field

Embodiments of the present disclosure described herein are related to a positive electrode for a rechargeable lithium battery and a rechargeable lithium battery including the positive electrode, and for example, to a positive electrode including a positive electrode active material layer having a double layer structure and a rechargeable lithium battery including the positive electrode including the positive electrode active material layer having the double layer structure.

### 2. Description of Related Art

Recently, the rapid proliferation of battery-powered electronics (such as mobile phones and/or laptop computers), and/or electric vehicles, has significantly increased the demand or desire for rechargeable batteries provided with relatively high energy density and relatively high capacity. Accordingly, extensive research has been directed towards enhancing (improving) the performance of rechargeable batteries, such as rechargeable lithium batteries.

Rechargeable lithium batteries include a positive electrode and a negative electrode, each including an active material that allows or facilitates the intercalation and deintercalation of lithium ions, along with an electrolyte solution. These batteries generate (produce) electrical energy from redox reactions (e.g., oxidation and reduction reactions) that occur as lithium ions are intercalated into or deintercalated from the positive electrode and the negative electrode.

### SUMMARY

Aspects according to one or more aspects of embodiments are directed toward a positive electrode with (having) high energy density, high operating voltage, and high conductivity.

Aspects according to one or more aspects of embodiments are directed toward a rechargeable lithium battery with (having) high energy density, high operating voltage, and high low-temperature properties.

Additional aspects will be set forth in part in the description which follows and, in part, will be apparent from the description, or may be learned by practice of the presented embodiments of the present disclosure.

In one or more embodiments of the present disclosure, a positive electrode for a rechargeable lithium battery includes a current collector; a first active material layer on the current collector; and a second active material layer on the first active material layer, wherein the first active material layer and the second active material layer each include a first particle, the second active material layer further includes a second particle, the first particle contains a compound of Formula 1, and the second particle contains a compound of Formula 2.

Formula 1 Liₐ₁Feₓ₁B1_{y1}PO_{4-b1}

In Formula 1 above, 0.8≤a1≤1.2, 0.95≤x1≤0.999, 0.001≤y1≤0.05, 0≤b1≤0.05, and x1 + y1 = 1 are satisfied, and in Formula 1 above, B1 is at least one element selected from among the group consisting of Ti, Mg, V, and Al.

Formula 2 Liₐ₂Niₓ₂Co_{y2}Al_{z2}B2_{w2}O_{2-b2}

In Formula 2 above, 0.8≤a2≤1.2, 0.8≤x2≤0.95, 0.02≤y2≤0.19, 0.001≤z2≤0.03 0≤w2≤0.1, 0≤b2≤0.05, and x2 + y2 + z2 + w2 = 1 are satisfied, and in Formula 2 above, B2 is at least one element selected from among the group consisting of Ti, Mg, Zr, and Al.

In one or more embodiments of disclosure, a positive electrode for a rechargeable lithium battery includes a current collector, a first active material layer on the current collector, and a second active material layer on the first active material layer, wherein the first active material layer and the second active material layer each include a first particle in the form of a single particle, the second active material layer further includes a second particle, the first particle contains a compound of Formula 1, and the second particle contains a compound of Formula 2.

Formula 1 Liₐ₁Feₓ₁B1_{y1}PO_{4-b1}

In Formula 1 above, 0.8≤a1≤1.2, 0.95≤x1≤0.999, 0.001≤y1≤0.05, 0≤b1≤0.05, and x1 + y1 = 1 are satisfied, and in Formula 1 above, B1 is at least one element selected from among the group consisting of Ti, Mg, V, and Al.

Formula 2 Liₐ₂Niₓ₂Co_{y2}Al_{z2}B2_{w2}O_{2-b2}

In Formula 2 above, 0.8≤a2≤1.2, 0.8≤x2≤0.95, 0.02≤y2≤0.19, 0.001≤z2≤0.03 0≤w2≤0.1, 0≤b2≤0.05, and x2 + y2 + z2 + w2 = 1 are satisfied, and in Formula 2 above, B2 is at least one element selected from among the group consisting of Ti, Mg, Zr, and Al.

In one or more embodiments of disclosure, a rechargeable lithium battery includes the positive electrode, a negative electrode including a negative electrode current collector and a negative electrode active material layer on the negative electrode current collector, and a separator between the positive electrode and the negative electrode.

At least some of the above and other features of the invention are set out in the claims.

### BRIEF DESCRIPTION OF THE DRAWINGS

The accompanying drawings are included to provide a further understanding of the present disclosure, and are incorporated in and constitute a part of this specification. The drawings illustrate embodiments of the present disclosure and, together with the description, serve to explain principles of the present disclosure. In the drawings:
FIG. 1 is a conceptual view showing a rechargeable lithium battery according to one or more embodiments of the present disclosure;
FIGS. 2-5 are schematic views each showing a rechargeable lithium battery according to one or more embodiments, and FIG. 2 shows a cylindrical battery, FIG. 3 shows a prismatic battery, and FIGS. 4 and 5 show pouch-type (kind) batteries;
FIG. 6 is a cross-sectional view showing a positive electrode for a rechargeable lithium battery according to one or more embodiments of the present disclosure;
FIG. 7 is an enlarged view showing a first active material layer of a positive electrode for a rechargeable lithium battery according to one or more embodiments of the present disclosure;
FIG. 8 is an enlarged view showing a first active material layer of a positive electrode for a rechargeable lithium battery according to one or more embodiments of the present disclosure;
FIG. 9 is a scanning electron microscope (SEM) image showing a first particle prepared in Preparation Example 1 of the present disclosure;
FIG. 10 is an SEM image showing a second particle in the form of a secondary particle, prepared in Preparation Example 2 of the present disclosure; and
FIG. 11 is an SEM image showing a second particle in the form of a single particle, prepared in Preparation Example 3 of the present disclosure.

### DETAILED DESCRIPTION

In order to sufficiently understand the configuration and effect of the present disclosure, one or more embodiments of the present disclosure will be described with reference to the accompanying drawings. It should be noted, however, that the present disclosure is not limited to the following example embodiments, and may be implemented in one or more suitable forms. Rather, the example embodiments are provided only to disclose the present disclosure and let those skilled in the art fully know the scope of the present disclosure.

In this description, it will be understood that, if (e.g., when) an element is referred to as being on another element, the element can be directly on the other element or intervening elements may be present between therebetween. In the drawings, thicknesses of some components are exaggerated for effectively explaining the technical contents. Like reference numerals refer to like elements throughout, and duplicative descriptions thereof may not be provided the specification.

Unless otherwise specially noted in this description, the expression of singular form may include the expression of plural form. In addition, unless otherwise specially noted, the phrase "A or B" may indicate "A but not B", "B but not A", and "A and B". The terms "comprises/includes" and/or "comprising/including" used in this description do not exclude the presence or addition of one or more other components.

As used herein, the term "and/or" includes any and all combinations of one or more of the associated listed items. As used herein, expressions such as "at least one of", "one of", and "selected from", when preceding a list of elements, modify the entire list of elements and do not modify the individual elements of the list. For example, "at least one of a, b or c", "at least one selected from a, b and c", etc., may indicate only a, only b, only c, both (e.g., simultaneously) a and b, both (e.g., simultaneously) a and c, both (e.g., simultaneously) b and c, all of a, b, and c, or variations thereof.

As used herein, the term "combination thereof" may refer to a mixture, a stack, a composite, a copolymer, an alloy, a blend, or a reaction product.

Unless otherwise especially defined in this description, a particle diameter may be an average particle diameter. When particles are spherical, "size" or "diameter" indicates a particle diameter or an average particle diameter, and when the particles are non-spherical, the "size" or "diameter" indicates a major axis length or an average major axis length. In addition, a particle diameter may indicate an average particle diameter (D50) where a cumulative volume is about 50 volume% in a particle size distribution. The average particle diameter (D50) may be measured by a method suitable to those skilled in the art, for example, by a particle size analyzer, a transmission electron microscope (TEM) image, or a scanning electron microscope (SEM) image. In one or more embodiments, a dynamic light-scattering measurement device is used to perform a data analysis, the number of particles is counted for each particle size range, and then from this, the average particle diameter (D50) value may be obtained through a calculation. Alternatively, a laser scattering method may be utilized to measure the average particle diameter (D50). In the laser scattering method, a target particle is distributed in a distribution solvent, introduced into a laser scattering particle-diameter measurement device (e.g., MT3000 commercially available from Microtrac, Inc), irradiated with ultrasonic waves of 28 kHz at a power of 60 W, and then an average particle diameter (D50) is calculated in the 50% standard of particle diameter distribution in the measurement device.

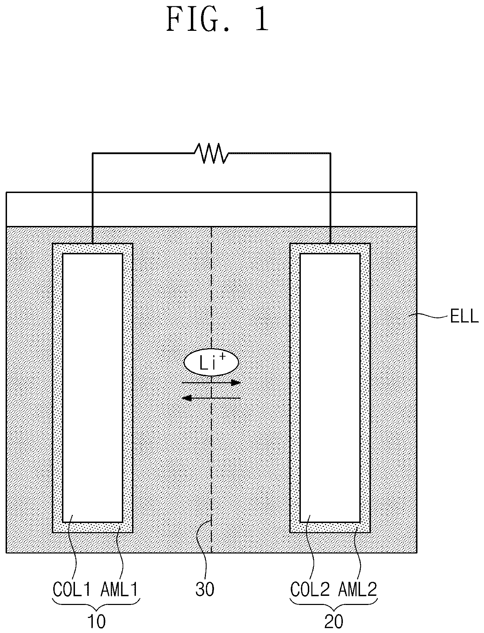

FIG. 1 is a cross-sectional view of a rechargeable lithium battery according to one or more embodiments of the present disclosure. Referring to FIG. 1, the rechargeable lithium battery may include a positive electrode 10, a negative electrode 20, a separator 30, and an electrolyte solution ELL.

The positive electrode 10 and the negative electrode 20 may be spaced and/or apart (e.g., spaced apart or separated) from each other by the separator 30. The separator 30 may be arranged between the positive electrode 10 and the negative electrode 20. The positive electrode 10, the negative electrode 20 and the separator 30 may be in contact with the electrolyte solution ELL. The positive electrode 10, the negative electrode 20 and the separator 30 may be impregnated in the electrolyte solution ELL.

The electrolyte solution ELL may be a medium for transferring lithium ions between the positive electrode 10 and the negative electrode 20. In the electrolyte solution ELL, the lithium ions may move through the separator 30 toward the positive electrode 10 or the negative electrode 20.

### Positive Electrode 10

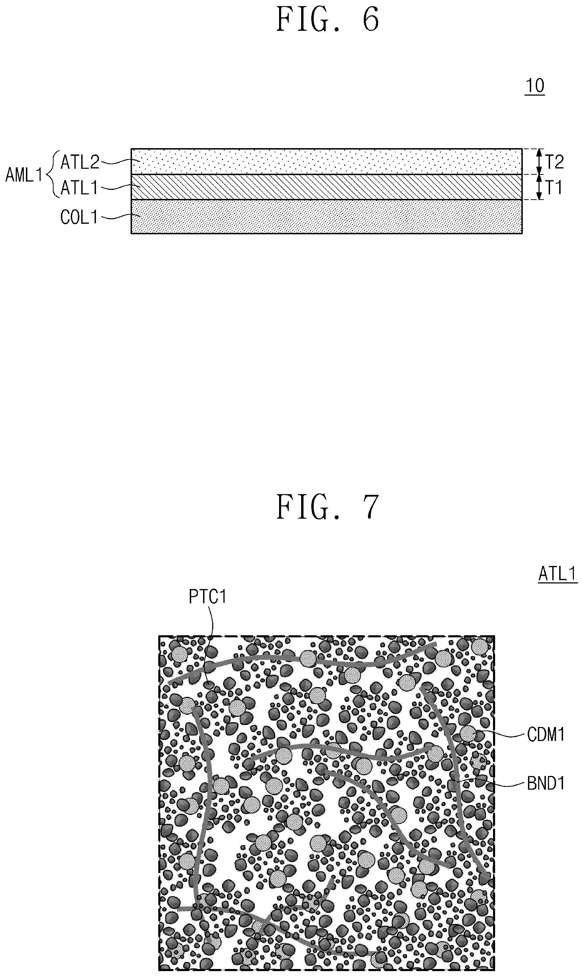

The positive electrode 10 for a rechargeable lithium battery includes a current collector COL1 and a positive electrode active material layer AML1 formed on the current collector COL1. The positive electrode active material layer AML1 includes a positive electrode active material and may further include a binder and/or a conductive material. The positive electrode 10 according to one or more embodiments of the present disclosure will be described in more detail with reference to FIG. 6. Al (aluminium) may be used for the current collector COL1, but the present disclosure is not limited thereto.

### Negative Electrode 20

The negative electrode 20 for a rechargeable lithium battery may include a current collector COL2 and a negative electrode active material layer AML2 on the current collector COL2. The negative electrode active material layer AML2 may include a negative electrode active material, and may further include a binder and/or a conductive material (e.g., an electrically conductive material).

For example, the negative electrode active material layer AML2 may include about 90 wt% to about 99 wt% of the negative electrode active material, about 0.5 wt% to about 5 wt% of the binder, and about 0 wt% to about 5 wt% of the conductive material.

The binder may serve to attach the negative electrode active material particles well to each other and also to attach the negative electrode active material well to the current collector COL2. The binder may include a non-aqueous binder, an aqueous binder, a dry binder, and/or a (e.g., any suitable) combination thereof.

The non-aqueous binder may include polyvinyl chloride, carboxylated polyvinyl chloride, polyvinyl fluoride, an ethylene propylene copolymer, polystyrene, polyurethane, polytetrafluoroethylene, polyvinylidene fluoride, polyethylene, polypropylene, polyamideimide, polyimide, and/or a (e.g., any suitable) combination thereof.

The aqueous binder may be selected from among a styrene-butadiene rubber, a (meth)acrylated styrene-butadiene rubber, a (meth)acrylonitrile-butadiene rubber, (meth)acrylic rubber, a butyl rubber, a fluoro rubber, polyethylene oxide, polyvinylpyrrolidone, polyepichlorohydrin, polyphosphazene, poly(meth)acrylonitrile, an ethylene propylene diene copolymer, polyvinylpyridine, chlorosulfonated polyethylene, latex, a polyester resin, a (meth)acrylic resin, a phenol resin, an epoxy resin, polyvinyl alcohol, and/or a (e.g., any suitable) combination thereof.

When an aqueous binder is used as the negative electrode binder, a cellulose-based compound capable of imparting viscosity may be further included. The cellulose-based compound may include at least one of carboxymethyl cellulose, hydroxypropylmethyl cellulose, methyl cellulose, or an alkali metal salt thereof. The alkali metal may include Na, K, or Li.

The dry binder may be a polymer material that is capable of being fibrous. For example, the dry binder may be polytetrafluoroethylene, polyvinylidene fluoride, a polyvinylidene fluoride-hexafluoropropylene copolymer, polyethylene oxide, and/or a (e.g., any suitable) combination thereof.

The conductive material (e.g., electron conductor) may be used to impart conductivity (e.g., electrical conductivity) to the electrode. Any material that does not cause chemical change (e.g., does not cause an undesirable chemical change in the rechargeable lithium battery) and that conducts electrons can be used in the battery. Non-limiting examples thereof may include a carbon-based material such as natural graphite, artificial graphite, carbon black, acetylene black, ketjen black, a carbon fiber, a carbon nanofiber, and a carbon nanotube; a metal-based material including copper, nickel, aluminium, silver, and/or the like in a form of a metal powder or a metal fiber; a conductive polymer such as a polyphenylene derivative; and/or a (e.g., any suitable) mixture thereof.

The negative current collector COL2 may include a copper foil, a nickel foil, a stainless steel foil, a titanium foil, a nickel foam, a copper foam, a polymer substrate coated with a conductive metal, and/or a (e.g., any suitable) combination thereof.

### Negative Electrode Active Material

The negative electrode active material may include a material that reversibly intercalates/deintercalates lithium ions, a lithium metal, a lithium metal alloy, a material capable of doping/dedoping lithium, or a transition metal oxide.

The material that reversibly intercalates/deintercalates lithium ions may include a carbon-based negative electrode active material, such as, for example, crystalline carbon, amorphous carbon and/or a (e.g., any suitable) combination thereof. The crystalline carbon may be graphite such as non-shaped, sheet-shaped, flake-shaped, sphere-shaped, or fiber-shaped natural graphite or artificial graphite. The amorphous carbon may be a soft carbon, a hard carbon, a mesophase pitch carbonization product, calcined coke, and/or the like.

The lithium metal alloy includes an alloy of lithium and a metal selected from among Na, K, Rb, Cs, Fr, Be, Mg, Ca, Sr, Si, Sb, Pb, In, Zn, Ba, Ra, Ge, Al, and Sn.

The material capable of doping/dedoping lithium may be a Si-based negative electrode active material or a Sn-based negative electrode active material. The Si-based negative electrode active material may include silicon, a silicon-carbon composite, SiOx (0 < x ≤ 2), a Si-Q alloy (where Q is selected from among an alkali metal, an alkaline-earth metal, a Group 13 element, a Group 14 element (excluding Si), a Group 15 element, a Group 16 element, a transition metal, a rare earth element, and/or a (e.g., any suitable) combination thereof). The Sn-based negative electrode active material may include Sn, SnOy (0 < y ≤ 2), e.g., SnO₂, a Sn-based alloy, and/or a (e.g., any suitable) combination thereof.

The silicon-carbon composite may be a composite of silicon and amorphous carbon. According to one or more embodiments, the silicon-carbon composite may include (e.g., may be in a form of) silicon particles and amorphous carbon coated on the surface of the silicon particles. For example, the silicon-carbon composite may include a secondary particle (core) in which primary silicon particles are agglomerated (e.g., be in a secondary particle form), and an amorphous carbon coating layer (shell) on the surface of the secondary particle. The amorphous carbon may also be between the primary silicon particles, and, for example, the primary silicon particles may be coated with the amorphous carbon. The secondary particle may exist dispersed in an amorphous carbon matrix.

The silicon-carbon composite may further include crystalline carbon. For example, the silicon-carbon composite may include a core including crystalline carbon and silicon particles and an amorphous carbon coating layer on a surface of the core.

The Si-based negative electrode active material or the Sn-based negative electrode active material may be used in combination with a carbon-based negative electrode active material.

### Separator 30

Depending on the type (kind) of the rechargeable lithium battery, the separator 30 may be present between the positive electrode 10 and the negative electrode 20. The separator 30 may include polyethylene, polypropylene, polyvinylidene fluoride, or a multilayer film of two or more layers thereof, and a mixed multilayer film such as a polyethylene/polypropylene two-layer separator, polyethylene/polypropylene/polyethylene three-layer separator, polypropylene/polyethylene/polypropylene three-layer separator, and/or the like.

The separator 30 may include a porous substrate and a coating layer including an organic material, an inorganic material, and/or a (e.g., any suitable) combination thereof on a surface (e.g., one or both surfaces (e.g., opposite surfaces) of the porous substrate).

The porous substrate may be a polymer film formed of any one selected from among polymer polyolefin such as polyethylene and polypropylene, polyester such as polyethylene terephthalate and polybutylene terephthalate, polyacetal, polyamide, polyimide, polycarbonate, polyether ketone, polyarylether ketone, polyetherimide, polyamideimide, polybenzimidazole, polyethersulfone, polyphenylene oxide, a cyclic olefin copolymer, polyphenylene sulfide, polyethylene naphthalate, a glass fiber, and polytetrafluoroethylene (e.g., TEFLON), or a copolymer or mixture of two or more thereof.

The organic material may include a polyvinylidene fluoride-based polymer or a (meth)acrylic polymer.

The inorganic material may include inorganic particles selected from among Al₂O₃, SiO₂, TiO₂, SnO₂, CeO₂, MgO, NiO, CaO, GaO, ZnO, ZrO₂, Y₂O₃, SrTiO₃, BaTiO₃, Mg(OH)₂, boehmite, and/or a (e.g., any suitable) combination thereof, but the present disclosure is not limited thereto.

The organic material and the inorganic material may be mixed in one coating layer, or a coating layer including an organic material and a coating layer including an inorganic material may be stacked. That is, the coating layer including an organic material may be on the coating layer including an inorganic material or the coating layer including an inorganic material may be on the coating layer including an organic material.

### Electrolyte Solution ELL

The electrolyte solution ELL for a rechargeable lithium battery may include a non-aqueous organic solvent and a lithium salt.

The non-aqueous organic solvent may serve as a medium for transmitting ions taking part in the electrochemical reaction of a battery.

The non-aqueous organic solvent may be a carbonate-based, ester-based, ether-based, ketone-based, or alcohol-based solvent, an aprotic solvent, and/or a (e.g., any suitable) combination thereof.

The carbonate-based solvent may include dimethyl carbonate (DMC), diethyl carbonate (DEC), dipropyl carbonate (DPC), methylpropyl carbonate (MPC), ethylpropyl carbonate (EPC), methylethyl carbonate (MEC), ethylene carbonate (EC), propylene carbonate (PC), butylene carbonate (BC), fluoroethylene carbonate (FEC), and/or the like.

The ester-based solvent may include methyl acetate, ethyl acetate, n-propyl acetate, dimethyl acetate, methyl propionate, ethyl propionate, decanolide, mevalonolactone, valerolactone, caprolactone, and/or the like.

The ether-based solvent may include dibutyl ether, tetraglyme, diglyme, dimethoxyethane, 2-methyltetrahydrofuran, 2,5-dimethyltetrahydrofuran, tetrahydrofuran, and/or the like. In addition, the ketone-based solvent may include cyclohexanone, and/or the like. The alcohol-based solvent may include ethanol, isopropyl alcohol, and/or the like and the aprotic solvent may include nitriles such as R-CN (wherein R is a C2 to C20 linear, branched, or cyclic hydrocarbon group, a double bond, an aromatic ring, or an ether bond), and/or the like; amides such as dimethylformamide; dioxolanes such as 1,3-dioxolane, 1,4-dioxolane, and/or the like; sulfolanes, and/or the like.

The non-aqueous organic solvents may be used alone or in combination of two or more.

In addition, if (e.g., when) using a carbonate-based solvent, a cyclic carbonate and a chain carbonate may be mixed and used, and the cyclic carbonate and the chain carbonate may be mixed in a volume ratio of about 1:1 to about 1:9.

The lithium salt dissolved in the organic solvent supplies lithium ions in a battery, enables a basic operation of a rechargeable lithium battery, and improves transportation of the lithium ions between positive and negative electrodes. Examples of the lithium salt include at least one selected from among LiPF₆, LiBF₄, LiSbF₆, LiAsF₆, LiClO₄, LiAlO₂, LiAlCl₄, LiPO₂F₂, LiCl, Lil, LiN(SO₃C₂F₃)₂, Li(FSO₂)₂N (lithium bis(fluorosulfonyl)imide, LiFSI), LiC₄F₉SO₃, LiN(CₓF₂ₓ₊1SO2)(C_{y}F_{2y+1}SO₂) (wherein x and y are integers of 1 to 20), lithium trifluoromethane sulfonate, lithium tetrafluoroethanesulfonate, lithium difluoro(oxalato)borate (LiDFOB), lithium difluorobis(oxalato)phosphate (LiDFBOP), and lithium bis(oxalato)borate (LiBOB).

### Rechargeable Lithium Battery

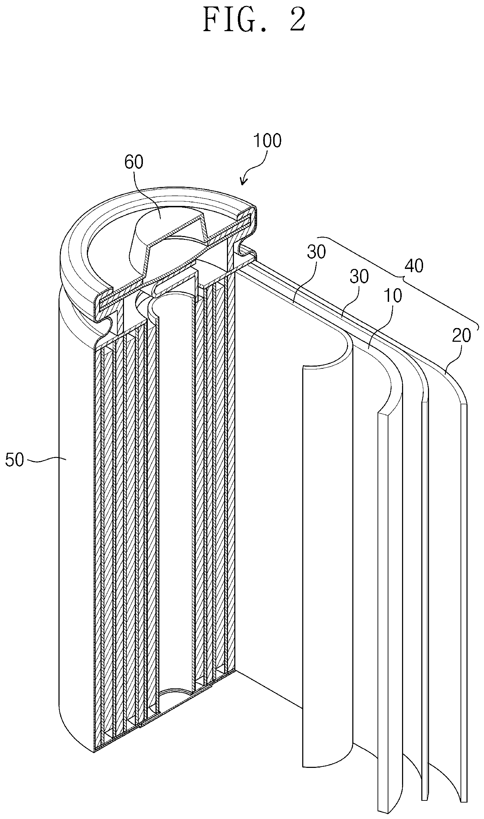

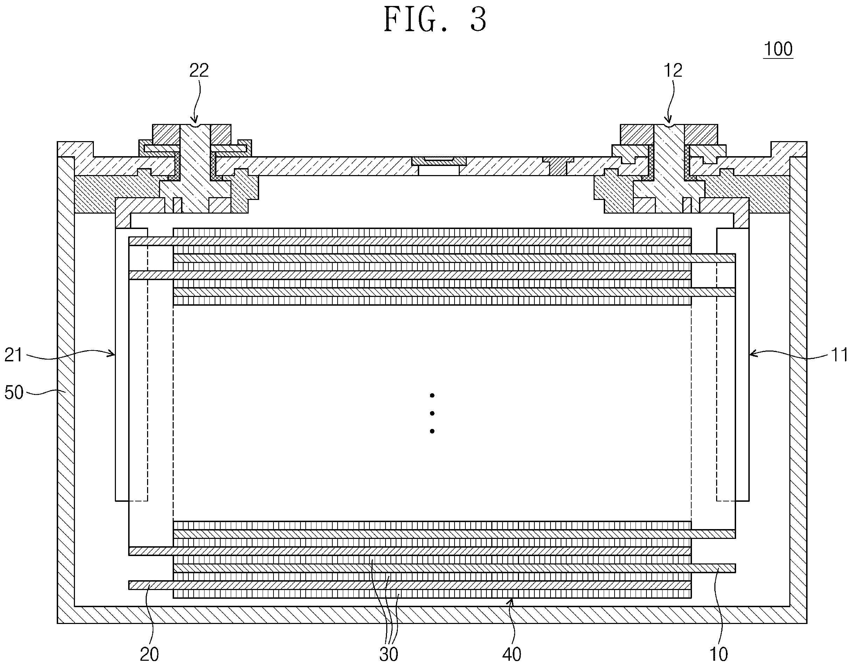

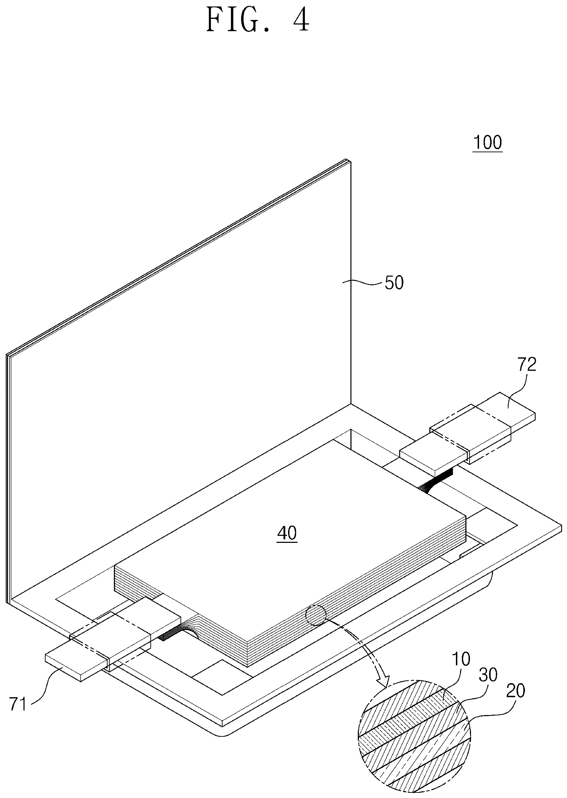

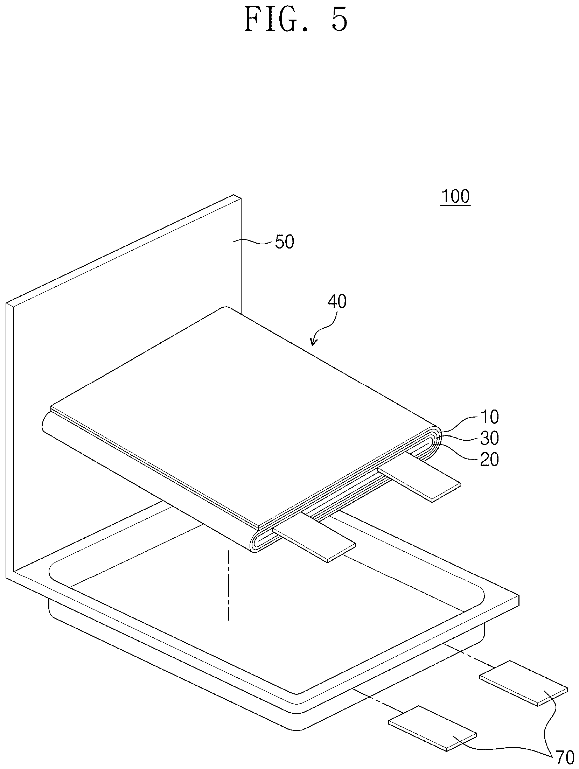

The rechargeable lithium battery may be classified into cylindrical, prismatic, pouch, or coin-type (kind) batteries, and/or the like depending on their shape. FIGS. 2 to 5 are schematic views each illustrating a rechargeable lithium battery according to one or more embodiments. FIG. 2 shows a cylindrical battery, FIG. 3 shows a prismatic battery, and FIGS. 4 and 5 show pouch-type (kind) batteries. Referring to FIGS. 2 to 5, the rechargeable lithium battery 100 may include an electrode assembly 40 including a separator 30 between a positive electrode 10 and a negative electrode 20, and a case 50 in which the electrode assembly 40 is included. The positive electrode 10, the negative electrode 20, and the separator 30 may be impregnated with an electrolyte solution. The rechargeable lithium battery 100 may include a sealing member 60 sealing the case 50, as shown in FIG. 2. In FIG. 3, the rechargeable lithium battery 100 may include a positive lead tab 11, a positive terminal 12, a negative lead tab 21, and a negative terminal 22. As shown in FIGS. 4 and 5, the rechargeable lithium battery 100 may include an electrode tab 70, which may be, for example, a positive electrode tab 71 and a negative electrode tab 72 serving as an electrical path for inducing the current formed in the electrode assembly 40 to the outside.

The rechargeable lithium battery according to one or more embodiments may be applied to automobiles, mobile phones, and/or one or more suitable types (kinds) of electric devices, as non-limiting examples.

FIG. 6 is a cross-sectional view showing a positive electrode for a rechargeable lithium battery according to one or more embodiments of the present disclosure.

Referring to FIG. 6, the positive electrode 10 for a rechargeable lithium battery includes the current collector COL1 (see FIG. 1) and the positive electrode active material layer AML1 (see FIG. 1) as described above. The positive electrode active material layer AML1 includes a first active material layer ATL1, and a second active material layer ATL2 stacked on the first active material layer ATL1.

FIG. 7 is an enlarged view showing a first active material layer of a positive electrode for a rechargeable lithium battery according to one or more embodiments of the present disclosure.

Referring to FIG. 7, the first active material layer ATL1 may include a first particle PTC1, a first binder BND1, and a first conductive material CDM1. The first active material layer ATL1 may further include an additive that may serve as a sacrificial positive electrode.

The first binder BND1 may combine the first particle PTC1 and the first conductive material CDM1. In addition, the first binder BND1 may stably fix the first active material layer ATL1 to the current collector COL1. For example, the first binder BND1 may include at least one selected from among the group consisting of polyvinyl alcohol, carboxymethyl cellulose, hydroxypropyl cellulose, diacetyl cellulose, polyvinyl chloride, carboxylated polyvinyl chloride, polyvinyl fluoride, an ethylene oxide-containing polymer, polyvinyl pyrrolidone, polyurethane, polytetrafluoroethylene, polyvinylidene fluoride, polyethylene, polypropylene, a styrene-butadiene rubber, a (meth)acrylated styrene-butadiene rubber, an epoxy resin, a (meth)acrylic resin, a polyester resin, and nylon, but the present disclosure is not limited thereto.

The first conductive material CDM1 may be used to improve conductivity of the first active material layer ATL1. Any conductive material that does not cause chemical changes in the first active material layer ATL1 may be used as the first conductive material CDM1 without limitation. For example, the first conductive material CDM1 may include a carbon-based material such as natural graphite, artificial graphite, carbon black, acetylene black, ketjen black, a carbon fiber, a carbon nanofiber, and a carbon nanotube; a metal-based material including copper, nickel, aluminium, silver, and/or the like in a form of a metal powder or a metal fiber; a conductive polymer such as a polyphenylene derivative; and/or a (e.g., any suitable) mixture thereof.

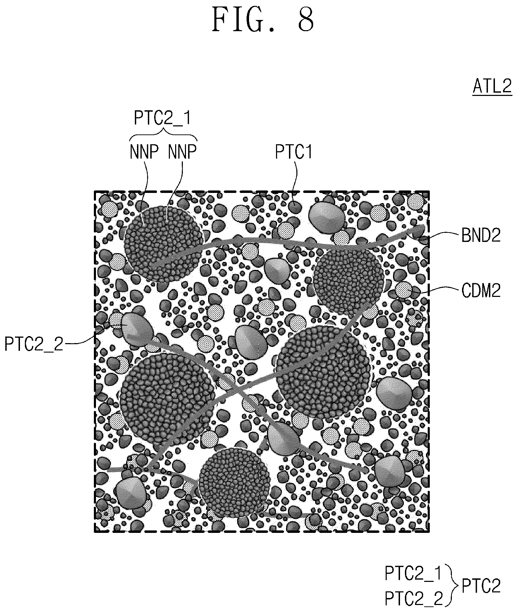

FIG. 8 is an enlarged view showing a second active material layer of a positive electrode for a rechargeable lithium battery according to one or more embodiments of the present disclosure.

Referring to FIG. 8, the second active material layer ATL2 may include a first particle PTC1, a second particle PTC2, a second binder BND2, and a second conductive material CDM2. The second active material layer ATL2 may further include an additive that may serve as a sacrificial positive electrode.

The second binder BND2 may combine the first particle PTC1, the second particle PTC2, and the second conductive material CDM2. In addition, the second binder BND2 may stably fix the second active material layer ATL2 onto the first active material layer ATL1. In one or more embodiments, the second binder BND2 may include at least one selected from among the group consisting of polyvinyl alcohol, carboxymethyl cellulose, hydroxypropyl cellulose, diacetyl cellulose, polyvinyl chloride, carboxylated polyvinyl chloride, polyvinyl fluoride, an ethylene oxide-containing polymer, polyvinyl pyrrolidone, polyurethane, polytetrafluoroethylene, polyvinylidene fluoride, polyethylene, polypropylene, a styrene-butadiene rubber, a (meth)acrylated styrene-butadiene rubber, an epoxy resin, a (meth)acrylic resin, a polyester resin, and nylon, but the present disclosure is not limited thereto.

The second conductive material CDM2 may be used to improve conductivity of the second active material layer ATL2. Any conductive material that does not cause chemical changes in the second active material layer ATL2 may be used as the second conductive material CDM2 without limitation. In one or more embodiments, the second conductive material CDM2 may include a carbon-based material such as natural graphite, artificial graphite, carbon black, acetylene black, ketjen black, a carbon fiber, a carbon nanofiber, and a carbon nanotube; a metal-based material including copper, nickel, aluminium, silver, and/or the like in a form of a metal powder or a metal fiber; a conductive polymer such as a polyphenylene derivative; and/or a (e.g., any suitable) mixture thereof.

Hereinafter, each of the first particle PTC1 and the second particle PTC2 will be described in more detail.

### First Particle PTC1

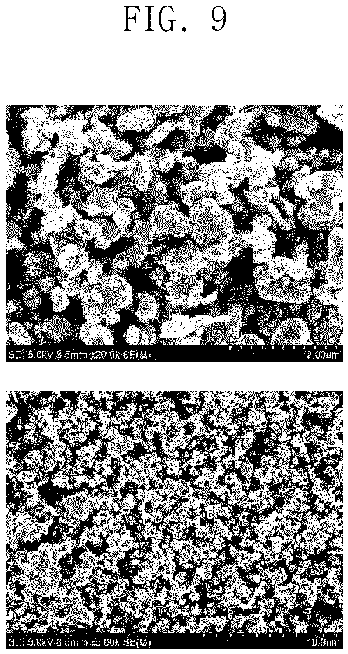

Referring to FIG. 9, the first particle PTC1 may be in the form of a single particle. Herein, the single particle may indicate a single type (kind) of particle having no grain boundary inside thereof. The single particle may indicate one single particle morphologically present in an independent phase in which particles are not aggregated (e.g., agglomerated) with one another, a particle having a monolith structure, a particle having a one-body structure, or a non-aggregated (e.g., agglomerated) particle. For example, the single particle may be a single crystal. In one or more embodiments, the single particle may be a particle containing several crystals. The single particle may be in a solely separated form. In one or more embodiments, the single particle may be in the form in which about 2 to about 100 single particles are attached to one another.

In one or more embodiments, the first particle PTC1 may be a first primary particle in the form that single particles are solely separated.

In one or more embodiments, the first particle PTC1 may be in the form that about 2 to about 100 of the first primary particles are attached together. In this case, the first particle PTC1 may not be spherical, unlike the second single particle PTC2_2, which will be described in more detail later. The first particle PTC1 may be in an irregular form.

The first particle PTC1 may have an average particle diameter of about 50 nm to about 5 µm, about 100 nm to about 3 µm, about 500 nm to about 2.5 µm, or about 1 µm. In one or more embodiments, the average particle diameter may be measured through a particle size analyzer. The average particle diameter may indicate a diameter (D50) of particles at a cumulative volume of about 50 vol% in a particle size distribution.

The minimum particle diameter of the first primary particle, that is, the particle diameter of the first primary particle, may be about 10 nm to about 900 nm, about 50 nm to about 500 nm, or about 200 nm to about 300 nm. In one or more embodiments, the minimum particle diameter of the first primary particle, that is, the particle diameter of the first primary particle, may indicate a diameter measured by randomly selecting about 30 first primary particles on an electron micrograph of a positive electrode active material. The first primary particles may be substantially uniform in size.

In one or more embodiments, the first particle PTC1 may include a first coating layer on a surface thereof. The first coating layer may entirely cover the surface of the first particle PTC1, or may partially cover the surface of the first particle PTC1. For example, the first coating layer may include carbon and/or a carbon-containing compound. The first coating layer may further include at least one selected from among the group consisting of a titanium-containing compound, a magnesium-containing compound, and a vanadium-containing compound. Metal-containing compounds, such as titanium-containing compounds, magnesium-containing compounds, and vanadium-containing compounds, may be, for example, metal oxides, metal hydroxides, metal carbonates, composites thereof, or mixtures thereof. The metal-containing compounds may further include other metals or non-metallic elements. For example, the metal-containing compounds may further include lithium. The first particle PTC1 may have improved structural stability and electrical conductivity through the first coating layer. That is, the first coating layer may improve the structural stability and electrical conductivity of the first particle PTC1.

The first particle PTC1 may include an olivine-based lithium compound represented by Formula 1.

Formula 1 Liₐ₁Feₓ₁B1_{y1}PO_{4-b1}

In Formula 1 above, 0.8≤a1≤1.2, 0.95≤x1≤0.999, 0.001≤y1≤0.05, 0≤b1≤0.05, and x1 + y1 = 1 are satisfied. B1 is at least one element selected from among the group consisting of Ti, Mg, V, and Al. B1 may be a dopant with which the first particle PTC1 is doped. For example, B1 may include Ti.

The first particle PTC1 may further include carbon from (e.g., derived from) the first coating layer described above. The first particle PTC1 may have a carbon element content (e.g., amount) of about 0.5 wt% to about 5 wt%, about 0.5 wt% to about 3 wt%, or about 0.5 wt% to about 2 wt% based on a total of 100 wt% of the first particle PTC1.

In one or more embodiments, the first particle PTC1 may exist as a single particle, meaning it has no internal grain boundaries and is not agglomerated with other particles. This single particle can be a single crystal or contain several crystals, and may exist independently or in clusters of 2 to 100 particles. The average particle diameter ranges from 50 nm to 5 µm, with primary particle sizes between 10 nm and 900 nm. PTC1 may include a surface coating layer, which can cover the entire or part of the surface, enhancing structural stability and electrical conductivity. This coating may contain carbon or compounds of titanium, magnesium, and vanadium. The olivine-based lithium compound in PTC1, may be represented Formula 1.

Formula 1 Liₐ₁Feₓ₁B1_{y1}PO_{4-b1},

includes specific ratios of elements, with Ti, Mg, V, and Al as dopants to improve battery performance. The particle may also have a carbon content of about 0.5 wt% to 5 wt%.

### Second Particle PTC2

Referring to FIG. 8, the second particle PTC2 may have two types (kinds) of particle forms. For example, the second particle PTC2 may include a second secondary particle PTC2_1 and a second single particle PTC2_2. For example, the second particle PTC2 may have a bimodal particle size distribution.

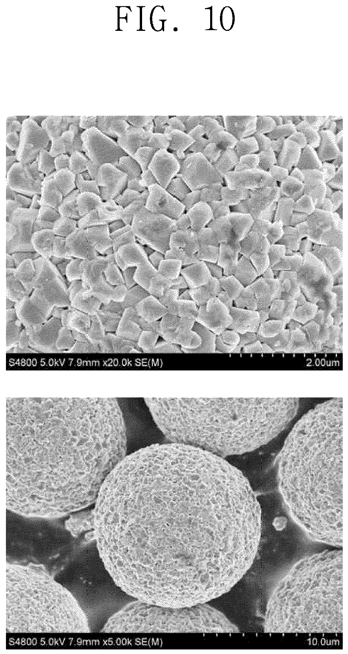

Referring to FIGS. 8 and 10, the second particle PTC2 is in the form of polycrystal and may be in the form of a second secondary particle PTC2_1 in which at least two second primary particles NNP are aggregated (e.g., agglomerated). For example, one second particle PTC2 may include a plurality of second primary particles NNP aggregated (e.g., agglomerated) together. The second particle PTC2 may be in the shape of sphere or oval.

In one or more embodiments, the second secondary particle PTC2_1 may include a second coating layer on a surface thereof. The second secondary particle PTC2_1 may include the second coating layer, and may thus effectively prevent or reduce structural collapse caused by repeated charging/discharging. Accordingly, rechargeable batteries may have improved lifetime characteristics.

The second coating layer may include a boron-containing compound, an aluminium-containing compound, and/or a (e.g., any suitable) combination thereof. Metal-containing compounds in the second coating layer may be, for example, metal oxides, metal hydroxides, metal carbonates, composites thereof, or mixtures thereof. The metal-containing compounds may further include other metals or non-metallic elements. For example, the second coating layer may further include lithium, manganese, and/or nickel.

A method of measuring the metal content (e.g., amount) in the second coating layer of the second secondary particle PTC2_1 may include performing scanning electron microscopy and energy dispersive X-ray spectroscopy (SEM-EDS) on the second secondary particle PTC2_1. Through the analysis described above, the content (e.g., amount) of boron and/or aluminium in the second coating layer may be determined. In addition to SEM-EDS, methods of measuring the metal content (e.g., amount) in the second coating layer may include inductively coupled plasma-mass spectrometry (ICP-MS), inductively coupled plasma optical emission spectroscopy (ICP-OES), and/or the like.

The second secondary particle PTC2_1 may have an average particle diameter (D50) of about 10 µm to about 18 µm or about 12 µm to about 16 µm. The average particle diameter of the second secondary particle PTC2_1 may be greater than the average particle diameter of the first particle PTC1 described above. In one or more embodiments, the average particle diameter may be measured through a particle size analyzer. The average particle diameter may indicate a diameter (D50) of particles at a cumulative volume of about 50 vol% in a particle size distribution.

The second secondary particle PTC2_1 may include a plurality of second primary particles NNP. The minimum particle diameter of the second primary particles NNP, for example, the particle diameter of the second primary particles NNP, may be about 100 nm to about 800 nm, about 150 nm to about 600 nm, or about 200 nm to about 400 nm. In one or more embodiments, if (e.g., when) the second primary particles NNP are spherical, the minimum particle diameter of the second primary particles NNP, for example, the particle diameter of the second primary particles NNP, may indicate a diameter measured by randomly selecting about 30 second primary particles NNP on an electron micrograph of the second particle PTC2. In one or more embodiments, if (e.g., when) the second primary particles NNP are non-spherical, the particle diameter of the second primary particles NNP may indicate a diameter of a sphere having the volume as measured by randomly selecting about 30 second primary particles NNP on an electron micrograph of the second particle PTC2.

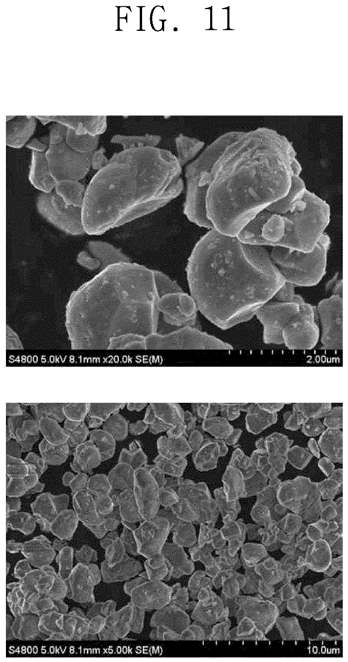

Referring to FIGS. 8 and 11, the second particle PTC2 may be in the form of a second single particle PTC2_2. For example, the second single particle PTC2_2 may have a single particle form similar to the above-described first particle PTC1. The description of the single particle may be substantially the same as or similar to what is previously described on the first particle PTC1. In one or more embodiments, the second single particle PTC2_2 may have a form constituted with one single particle. In one or more embodiments, the second single particle PTC2_2 may have a form in which a plurality of single particles are attached together.

In one or more embodiments, the second single particle PTC2_2 may include a second coating layer on a surface thereof. The second single particle PTC2_2 may include the second coating layer, and may thus effectively prevent or reduce structural collapse caused by repeated charging/discharging. Accordingly, rechargeable batteries may have improved lifetime characteristics.

The second coating layer may include a boron-containing compound, an aluminium-containing compound, and/or a (e.g., any suitable) combination thereof. Metal-containing compounds in the second coating layer may be, for example, metal oxides, metal hydroxides, metal carbonates, composites thereof, or mixtures thereof. The metal-containing compounds may further include other metals or non-metallic elements. For example, the second coating layer may further include lithium, manganese, and/or nickel.

A method of measuring the metal content (e.g., amount) in the second coating layer of the second single particle PTC2_2 may include performing scanning electron microscopy and energy dispersive X-ray spectroscopy (SEM-EDS) on the second single particle PTC2_2. Through the analysis described above, the content (e.g., amount) of boron and/or aluminium in the second coating layer may be determined. In addition to SEM-EDS, methods of measuring the metal content (e.g., amount) in the second coating layer may include inductively coupled plasma-mass spectrometry (ICP-MS), inductively coupled plasma optical emission spectroscopy (ICP-OES), and/or the like.

The second single particle PTC2_2 may have an average particle diameter of about 2 µm to about 6 µm, about 3 µm to about 5 µm, or about 3.5 µm to about 4.5 µm. The average particle diameter of the second single particle PTC2_2 may be greater than the average particle diameter of the first particle PTC1 described above. In one or more embodiments, the average particle diameter may be measured through a particle size analyzer. The average particle diameter may indicate a diameter (D50) of particles at a cumulative volume of about 50 vol% in a particle size distribution.

As described above, the second single particle PTC2_2 may be in a solely separated form. In one or more embodiments, the second single particle PTC2_2 may be in the form in which a plurality of single particles are attached together. The shape of a plurality of single particles attached together may not be spherical, unlike the second secondary particle PTC2_1. For example, the shape of a plurality of single particles attached together may be in an irregular form.

The second particle PTC2, which may have the form of a second secondary particle PTC2_1 or a second single particle PTC2_2, may have an average particle diameter of about 6 µm to about 22 µm, about 8 µm to about 20 µm, or about 10 µm to about 18 µm. In one or more embodiments, the average particle diameter may be measured through a particle size analyzer. The average particle diameter may indicate a diameter (D50) of particles at a cumulative volume of about 50 vol% in a particle size distribution.

The second particle PTC2 is a nickel-based active material and includes a lithium nickel-based composite oxide. For example, the second particle PTC2 may include a high nickel-based positive electrode active material containing a high content (e.g., amount) of nickel. The high nickel-based positive electrode active material may achieve high capacity and high performance.

For example, the second particle PTC2 may include a layered lithium nickel-based composite oxide represented by Formula 2.

Formula 2 Liₐ₂Niₓ₂Co_{y2}Al_{z2}B2_{w2}O_{2-b2}

In Formula 2 above, 0.8≤a2≤1.2, 0.8≤x2≤0.95, 0.02≤y2≤0.19, 0.001≤z2≤0.03 0≤w2≤0.1, 0≤b2≤0.05, and x2 + y2 + z2 + w2 = 1 are satisfied.

B2 is at least one element selected from among the group consisting of Mg, Ti, Zr, and Al. B2 may be a dopant with which the second particle PTC2 is doped. Formula 3 indicates a case in which w2 is 0, and indicates a lithium nickel-based composite oxide that is not doped with B2. For example, the case indicates a lithium nickel-based composite oxide having a layered structure represented by Formula 3.

Formula 3 Liₐ₃Niₓ₃Co_{y3}Al_{z3}O_{2-b3}

In Formula 3 above, 0.8≤a3≤1.2, 0.8≤x3≤0.95, 0.02≤y3≤0.19, 0.001≤z3≤0.03, 0≤b3≤0.05, and x3 + y3 + z3 = 1 may be satisfied.

The second active material layer ATL2 according to the present disclosure includes the second particle PTC2, and may thus allow rechargeable batteries to obtain high capacity and high energy density. In one or more embodiments, the second active material layer ATL2 includes both (e.g., simultaneously) the first particle PTC1 and the second particle PTC2, and may thus allow high energy density and excellent or suitable low-temperature characteristics.

In one or more embodiments, the second particle PTC2 can exist in two forms: as a secondary particle (PTC2_1) or as a single particle (PTC2_2), resulting in a bimodal particle size distribution. The secondary particle PTC2_1 is a polycrystal form where primary particles (NNP) aggregate, typically having a spherical or oval shape with an average diameter between 10 µm and 18 µm. These secondary particles may include a coating layer containing compounds like boron or aluminium to enhance structural stability and battery lifespan. The single particle PTC2_2, similar to the first particle PTC1, can exist independently or in clusters, with an average diameter ranging from 2 µm to 6 µm. This form may also benefit from a coating layer to prevent structural collapse during charging and discharging cycles. Both forms of PTC2 incorporate specific elements to enhance battery performance, with the secondary particles generally being larger than the single particles. Additionally, PTC2 is a nickel-based active material that may include a high nickel-content lithium nickel-based composite oxide, represented by Formula 2.

Formula 2 Liₐ₂Niₓ₂Co_{y2}Al_{z2}B2_{w2}O_{2-b2},

which contributes to high capacity and high performance in rechargeable batteries.

Referring back to FIG. 6, the positive electrode active material layer AML1 according to one or more embodiments of the present disclosure will be described in more detail.

The positive electrode active material layer AML1 includes a first active material layer ATL1, and a second active material layer ATL2 stacked on the first active material layer ATL1.

The first active material layer ATL1 may include at least one of the first particle PTC1 and the second particle PTC2. The positive electrode of the present disclosure includes the first particle PTC1 which is an olivine-based particle, in the first active material layer, and may thus improve energy density.

The first active material layer ATL1 may further include a first binder BND1 and a first conductive material CDM1.

The second active material layer ATL2 includes the second particle PTC2. The second particle PTC2 includes a high nickel-based positive electrode active material, and may thus achieve higher capacity than the first particle PTC1. The second active material layer ATL2 includes the second particle PTC2, and may thus improve pellet density, capacity, and energy density. For example, in the positive electrode of the present disclosure, low-temperature characteristics may be significantly improved by placing the second active material layer containing the second particle PTC2 on a surface of a positive electrode in which electrochemical reactions take place most actively. The second active material layer ATL2 may further include the first particle PTC1.

In one or more embodiments, with respect to a total content (e.g., amount) of the first particle PTC1 and the second particle PTC2 in the second active material layer ATL2, the second particle PTC2 may amount to about 30 wt% to about 70 wt%, about 40 wt% to about 60 wt%, or about 45 wt% to about 55 wt%.

The second active material layer ATL2 may further include a second binder BND2 and a second conductive material CDM2.

The first active material layer ATL1 may include about 5 to about 10 parts by weight of the first binder BND1 with respect to 100 parts by weight of the first active material layer ATL1.

The second active material layer ATL2 may include about 2 to about 5 parts by weight of the second binder BND2 with respect to 100 parts by weight of the second active material layer ATL2.

The content (e.g., amount) of the first binder BND1 included in the first active material layer ATL1 may be greater than the content (e.g., amount) of the second binder BND2 included in the second active material layer ATL2.

The first particle PTC1 in the form of a single particle has a very small average particle diameter, and accordingly, a large amount of the first binder BND1 may be desired or required to attach the first particle PTC1 to the current collector COL1 (see FIG. 1) or to fix the first particle PTC1 onto the first conductive material CDM1. In one or more embodiments, the second particle PTC2 has a greater average particle diameter than the first particle PTC1, and accordingly, a relatively small amount of the second binder BND2 may be desired or required to attach the second particle PTC2 onto the first active material layer ATL1 or to fix the second particle PTC2 onto the second conductive material CDM2. Accordingly, the content (e.g., amount) of the second binder BND2 in the second active material layer ATL2 containing the second particle PTC2 may be reduced.

The first active material layer ATL1 may include about 10 to about 15 parts by weight of the first conductive material CDM1 with respect to 100 parts by weight of the first active material layer ATL1.

The second active material layer ATL2 may include about 5 to about 10 parts by weight of the second conductive material CDM2 with respect to 100 parts by weight of the second active material layer ATL2.

The weight of the first conductive material CDM1 included in the first active material layer ATL1 may be greater than the weight of the second conductive material CDM2 included in the second active material layer ATL2.

With respect to a total content (e.g., amount) of the first particle PTC1 and the second particle PTC2 in the positive electrode active material layer AML1, the second particle PTC2 may amount to about 5 wt% to about 25 wt%, about 10 wt% to about 20 wt%, or about 15 wt% to about 20 wt%.

With respect to a total content (e.g., amount) of the first particle PTC1 and the second particle PTC2 in the second active material layer ATL2, the second particle PTC2 may amount to about 30 wt% to about 70 wt%, about 40 wt% to about 60 wt%, or about 45 wt% to about 55 wt%.

The first active material layer ATL1 may have a thickness T1. In one or more embodiments, T1 may increase with a rise in content (e.g., amount) of the first particle PTC1 included in the first active material layer ATL1. That is, an increase in the content of the first particle PTC1 may increase a thickness T1 of the first active material layer ATL1. The second active material layer ATL2 may have a thickness T2. In one or more embodiments, T2 may increase with a rise in content (e.g., amount) of the second particle PTC2 included in the second active material layer ATL2. That is, an increase in the content of the second particle PTC2 may increase a thickness T2 of the second active material layer ATL2. In one or more embodiments, the size of T2 with respect to the sum of T1 and T2 (T2/(T1+T2) may be about 0.1 to about 0.5, about 0.2 to about 0.4, or about 0.25 to about 0.35. Within the ranges described above, low-temperature characteristics may be improved while excellent or suitable energy density is maintained.

In one or more embodiments, the first active material layer ATL1 may have a loading level of about 5 mg/cm² to about 10 mg/cm². The second active material layer ATL2 may have a loading level of about 5 mg/cm² to about 25 mg/cm².

In one or more embodiments, the positive electrode active material layer AML1 of the present disclosure may have a pellet density of about 2.5 g/cc to about 3.0 g/cc.

A rechargeable lithium battery including the positive electrode according to one or more embodiments of the present disclosure may have improved low-temperature characteristics.

Hereinafter, Preparation Examples, Examples, and Comparative Examples of the present disclosure will be described in more detail. However, the following Examples are presented only as one or more embodiments of the present disclosure, and the present disclosure is not limited by the following Examples.

### Preparation Example 1: Preparation of First Particle in Single Particle Form olivine-based active material

An iron phosphate precursor (Fe₁PO₄), lithium carbonate, and titanium dioxide were mixed at a molar ratio of Fe:Li:Ti of 1:1.03:0.03. 10 wt% of glucose was added to the mixture. The mixture was subjected to a wet grinding process through ball milling. The mixture was evaporated to dryness on a heating tray and then placed and dried in a vacuum oven at 120 °C for 4 hours. The dried mixture was fired at 750 °C for 10 hours in a nitrogen atmosphere. The fired product was ground to obtain a first particle in the form of a single particle. Using a scanning electron microscope (SEM), first primary particles constituting the first particle were found to have a particle diameter of about 200 nm to about 300 nm, and the first particle was found to have a D50 of about 1 µm. In addition, using scanning electron microscopy and energy dispersive X-ray spectroscopy (SEM-EDS), the primary particle of the first particle was found to contain 1.52 wt% of carbon.

### Preparation Example 2: Preparation of Second Particle in Secondary Particle Form large particle layered active material

A high nickel-based precursor was prepared using a coprecipitation method. For example, as raw materials for nickel-based metal hydroxide, nickel sulfate (NiSO₄·6H₂O), cobalt sulfate (CoSO₄·7H₂O), and aluminium sulfate (Al₂(SO₄)₃·18H₂O) were stirred in distilled water as a solvent at a molar ratio of Ni:Co:Al of 88.5:10:1.5 for 10 to 20 hours to prepare a metal raw material mixture. The metal raw material mixture, aqueous ammonia, and sodium hydroxide were added into a reactor and subjected to reactions. The slurry solution in the reactor was filtered and washed with high purity distilled water. The washed material was dried in a hot air oven at 210 °C for 24 hours to obtain a large particle precursor (Ni_{0.88.5}Co_{0.10}Al_{0.015}(OH)₂) powder having an average particle diameter of about 14 µm.

The high nickel-based precursor and anhydrous lithium hydroxide (LiOH) were dry mixed using a Henschel mixer. Lithium and transition metal were mixed at a molar ratio of about 1:1. The transition metal is the sum total of transition metals contained in the high nickel-based precursor (Ni+Co+Al). A melting agent was further added to the mixture, and the mixture was heat treated (i.e., firing process) at about 750 °C for 15 hours in an oxygen atmosphere to synthesize a second particle as a high nickel-based positive electrode active material. The second particle was ground using a jet mill at a pressure of 3 bar.

The second particle was added to distilled water and washed. Boron oxide and aluminium oxide corresponding to 3 mol% with respect to the total of transition metals in the second particle were added to perform boron and aluminium coating. The second particle was dried at about 150 °C for about 12 hours and was subjected to a heat treatment (i.e., surface treatment) at about 700 °C for 15 hours in an oxygen atmosphere.

### Preparation Example 3: Preparation of Second Particle in Single Particle Form small particle layered active material

A high nickel-based precursor was prepared using a coprecipitation method. For example, as raw materials for nickel-based metal hydroxide, nickel sulfate (NiSO₄·6H₂O), cobalt sulfate (CoSO₄·7H₂O), and aluminium sulfate (Al₂(SO₄)₃·18H₂O) were stirred in distilled water as a solvent at a molar ratio of Ni:Co:Al of 88.5:10:1.5 for 30 hours to prepare a metal raw material mixture. The metal raw material mixture, aqueous ammonia, and sodium hydroxide were added into a reactor and subjected to reactions. The slurry solution in the reactor was filtered and washed with high purity distilled water. The washed material was dried in a hot air oven at 210 °C for 24 hours to obtain a small particle precursor (Ni_{0.885}Co_{0.10}Al_{0.015}(OH)₂) powder having an average particle diameter of about 4 µm.

The high nickel-based precursor and anhydrous lithium hydroxide (LiOH) were dry mixed using a Henschel mixer. Lithium and transition metal were mixed at a molar ratio of about 1:1. The transition metal is the sum total of transition metals contained in the high nickel-based precursor (Ni+Co+Al). A melting agent was further added to the mixture, and the mixture was heat treated (i.e., firing process) at about 750 °C for 15 hours in an oxygen atmosphere to synthesize a second particle as a high nickel-based positive electrode active material. The second particle was ground using a jet mill at a pressure of 4 bar.

The second particle was added to distilled water and washed. Boron oxide and aluminium oxide corresponding to 3 mol% with respect to the total of transition metals in the second particle were added to perform boron and aluminium coating. The second particle was dried at about 150 °C for about 12 hours and was subjected to a heat treatment (i.e., surface treatment) at about 700 °C for 15 hours in an oxygen atmosphere.

In other words, Preparation Example 1 describes the creation of a single particle form of an olivine-based active material. An iron phosphate precursor, lithium carbonate, and titanium dioxide were mixed with glucose and subjected to wet grinding. The mixture was dried and then fired in a nitrogen atmosphere. The resulting product, with primary particles sized between 200 nm and 300 nm, had a D50 of about 1 µm and contained 1.52 wt% carbon.

Preparation Example 2 details the production of a secondary particle form of a large particle layered active material. A high nickel-based precursor was prepared using nickel sulfate, cobalt sulfate, and aluminium sulfate, which were mixed, reacted, and dried to form a precursor powder with an average diameter of 14 µm. This precursor was mixed with lithium hydroxide and heat-treated to create a high nickel-based positive electrode active material. The particles were then coated with boron and aluminium oxides and subjected to further heat treatment.

Preparation Example 3 outlines the preparation of a single particle form of a small particle layered active material. Similar to Example 2, a high nickel-based precursor was prepared and mixed with lithium hydroxide. The mixture was heat-treated to form a high nickel-based positive electrode active material, which was then coated with boron and aluminium oxides and heat-treated. The resulting small particle precursor had an average diameter of 4 µm.

### Preparation Example 4: Mixing of Second Particle

The second particle in the form of a secondary particle prepared through Preparation Example 2 and the second particle in the form of a single particle prepared through Preparation Example 3 were mixed at a weight ratio of 3:1 to prepare a bimodal second particle.

### Example 1: Positive Electrode including First Active Material Layer and Second Active Material Layer first particle in first active material layer: first particle in second active material layer: second particle in second active material layer = 90%: 5%: 5%

The first particle prepared through Preparation Example 1, the first binder (polyvinylidene fluoride), and the first conductive material (carbon black) were dispersed in N-methylpyrrolidone at a weight ratio of 1:0.1:0.15 to prepare a first active material slurry.

The first particle prepared through Preparation Example 1, the bimodal second particle prepared through Preparation Example 4, the second binder (polyvinylidene fluoride), and the second conductive material (carbon black) were dispersed in N-methylpyrrolidone at a weight ratio of 1:0.05:0.1 to prepare a second active material slurry.

The first active material slurry was applied onto a 15 µm thick aluminium (Al) thin film, which is a positive electrode current collector, and dried to form a first active material layer. The second active material slurry was applied onto the first active material layer and dried to form a second active material layer. In this case, the first active material layer and the second active material layer were formed such that the content (e.g., amount) of the first particle in the first active material layer was 90 wt%, the content (e.g., amount) of the first particle in the second active material layer was 5 wt%, and the content (e.g., amount) of the second particle in the second active material layer was 5 wt% with respect to a total content (e.g., amount) of the first particle and the second particle. Through a roll press, a positive electrode in which the aluminium current collector, the first active material layer, and the second active material layer were stacked in this order was prepared.

### Example 2: Positive Electrode including First Active Material Layer and Second Active Material Layer first particle in first active material layer: first particle in second active material layer: second particle in second active material layer = 80%: 10%: 10%

A positive electrode was prepared in substantially the same manner as in Example 1, except that the first active material layer and the second active material layer were formed such that the content (e.g., amount) of the first particle in the first active material layer was 80 wt%, the content (e.g., amount) of the first particle in the second active material layer was 10 wt%, and the content (e.g., amount) of the second particle in the second active material layer was 10 wt% with respect to a total content (e.g., amount) of the first particle and the second particle.

### Example 3: Positive Electrode including First Active Material Layer and Second Active Material Layer first particle in first active material layer: first particle in second active material layer: second particle in second active material layer = 70%: 15%: 15%

A positive electrode was prepared in substantially the same manner as in Example 1, except that the first active material layer and the second active material layer were formed such that the content (e.g., amount) of the first particle in the first active material layer was 70 wt%, the content (e.g., amount) of the first particle in the second active material layer was 15 wt%, and the content (e.g., amount) of the second particle in the second active material layer was 15 wt% with respect to a total content (e.g., amount) of the first particle and the second particle.

### Example 4: Positive Electrode including First Active Material Layer and Second Active Material Layer first particle in first active material layer: first particle in second active material layer: second particle in second active material layer = 60%: 20%: 20%

A positive electrode was prepared in substantially the same manner as in Example 1, except that the first active material layer and the second active material layer were formed such that the content (e.g., amount) of the first particle in the first active material layer was 60 wt%, the content (e.g., amount) of the first particle in the second active material layer was 20 wt%, and the content (e.g., amount) of the second particle in the second active material layer was 20 wt% with respect to a total content (e.g., amount) of the first particle and the second particle.

### Example 5: Positive Electrode including First Active Material Layer and Second Active Material Layer first particle in first active material layer: first particle in second active material layer: third particle in second active material layer = 50%: 25%: 25%

A positive electrode was prepared in substantially the same manner as in Example 1, except that the first active material layer and the second active material layer were formed such that the content (e.g., amount) of the first particle in the first active material layer was 50 wt%, the content (e.g., amount) of the first particle in the second active material layer was 25 wt%, and the content (e.g., amount) of the second particle in the second active material layer was 25 wt% with respect to a total content (e.g., amount) of the first particle and the second particle.

### Comparative Example 1: Positive Electrode including Active Material Layer with Single Layer Structure First Particle

The first particle prepared through Preparation Example 1, the first binder (polyvinylidene fluoride), and the first conductive material (carbon black) were dispersed in N-methylpyrrolidone at a weight ratio of 1:0.1:0.15 to prepare a positive electrode active material slurry.

The positive electrode active material slurry was applied onto a 15 µm thick aluminium (Al) thin film, which is a positive electrode current collector, and dried. Through a roll press, a positive electrode in which a positive electrode active material layer was stacked on the aluminium current collector was prepared.

### Comparative Example 2: Positive Electrode including Active Material Layer with Single Layer Structure Second Particle

The second particle prepared through Preparation Example 4, the binder (polyvinylidene fluoride), and the conductive material (carbon black) were dispersed in N-methylpyrrolidone at a weight ratio of 1:0.05:0.1 to prepare a positive electrode active material slurry.

The positive electrode active material slurry was applied onto a 15 µm thick aluminium (Al) thin film, which is a positive electrode current collector, and dried. Through a roll press, a positive electrode in which a positive electrode active material layer was stacked on the aluminum current collector was prepared.

### Comparative Example 3: Positive Electrode including Active Material Layer with Single Layer Structure First Particle : Second Particle = 80% : 20%

The first particle and the second particle prepared through Preparation Examples 1 and 4 were mixed at a weight ratio of 4:1 to prepare a mixed active material. The mixed active material, a binder (polyvinylidene fluoride), and a conductive material (carbon black) were dispersed in N-methylpyrrolidone at a weight ratio of 1:0.1:0.15 to prepare a positive electrode active material slurry. The positive electrode active material slurry was applied onto a 15 µm thick aluminium (Al) thin film, which is a positive electrode current collector, and dried. Through a roll press, a positive electrode in which a positive electrode active material layer was stacked on the aluminium current collector was prepared.

### Comparative Example 4: Positive Electrode including Second Active Material Layer with No First Particle

The first particle prepared through Preparation Example 1, the first binder (polyvinylidene fluoride), and the first conductive material (carbon black) were dispersed in N-methylpyrrolidone at a weight ratio of 1:0.1:0.15 to prepare a first active material slurry.

The second particle prepared through Preparation Example 4, the second binder (polyvinylidene fluoride), and the second conductive material (carbon black) were dispersed in N-methylpyrrolidone at a weight ratio of 1:0.05:0.1 to prepare a second active material slurry.

The first active material slurry was applied onto a 15 µm thick aluminium (Al) thin film, which is a positive electrode current collector, and dried to form a first active material layer. The second active material slurry was applied onto the first active material layer and dried to form a second active material layer. In this case, the first active material layer and the second active material layer were formed such that the content (e.g., amount) of the first particle in the first active material layer was 80 wt% and the content (e.g., amount) of the second particle in the second active material layer was 20 wt% with respect to a total content (e.g., amount) of the first particle and the second particle. Through a roll press, a positive electrode in which the aluminium current collector, the first active material layer, and the second active material layer were stacked in this order was prepared.

### Comparative Example 5: Positive Electrode having First Active Material Layer Stacked on Second Active Material Layer

A positive electrode was prepared in substantially the same manner as in Example 4, except that the aluminium current collector, the second active material layer, and the first active material layer were stacked in this order. For example, the second active material layer was placed on the aluminium current collector, and the first active material layer was placed on the second active material layer.

### Preparation of Negative Electrode

Graphite (95 wt%), a binder (3 wt%), and a conductive material (2 wt%) were mixed in an N-methylpyrrolidone solvent to prepare a negative electrode active material slurry. The negative electrode active material slurry was applied onto a copper current collector, dried, and rolled to prepare a negative electrode.

### Preparation of Rechargeable Lithium Battery

A coin full cell was prepared using the positive electrode and the negative electrode prepared. A polypropylene film (Celgard 3510) was used as a separator. As an electrolyte, an electrolyte solution obtained by mixing 1.3 M LiPF₆ with a mixture solvent of ethylene carbonate (EC), diethyl carbonate (DEC), and fluoroethylene carbonate (FEC) (2:6:2 by volume ratio) was used.

### Evaluation Example 1: Analysis of Positive Electrode Active Material Surface

SEM images for the first particles and the second particles prepared in Preparation Examples 1 to 3 are shown in FIGS. 9 to 11. Referring to FIG. 9, it is determined that the first particle according to one or more embodiments of the present disclosure is in the form of a fine single particle having a size of several hundred nanometers. Referring to FIG. 10, it is determined that the second particle in the form of a secondary particle according to one or more embodiments of the present disclosure is in the form of a secondary particle having a size of several micrometers. It is determined that the second particle in the form of a secondary particle is in the form of a secondary particle in which a plurality of primary particles are aggregated (e.g., agglomerated). Referring to FIG. 11, it is determined that the second particle in the form of a single particle according to one or more embodiments of the present disclosure is in the form of a single particle having a size of several micrometers.

### Evaluation Example 2: Analysis of Positive Electrode Properties

The content (e.g., amount) of each particle according to Examples 1 to 5 and Comparative Examples 1 to 5 is shown in Table 1.

**Table 1**

| Item | Composition | | Form of positive electrode active material |
|---|---|---|---|
| | First active material layer | Second active material layer | |
| Example 1 | 90 wt% of first particle | 5 wt% of first particle, 5 wt% of second particle | Second active material layer stacked on first active material layer |
| Example 2 | 80 wt% of first particle | 10 wt% of first particle, 10 wt% of second particle | Second active material layer stacked on first active material layer |
| Example 3 | 70 wt% of first particle | 15 wt% of first particle, 15 wt% of second particle | Second active material layer stacked on first active material layer |
| Example 4 | 60 wt% of first particle | 20 wt% of first particle, 20 wt% of second particle | Second active material layer stacked on first active material layer |
| Example 5 | 50 wt% of first particle | 25 wt% of first particle, 25 wt% of second particle | Second active material layer stacked on first active material layer |
| Comparati ve Example 1 | 100 wt% of first particle | | Single layer |
| Comparati ve Example 2 | 100 wt% of second particle | | Single layer |
| Comparati ve Example 3 | 80 wt% of first particle, 20 wt% of second particle | | Single layer |
| Comparati ve Example 4 | 80 wt% of first particle | 20 wt% of second particle | Second active material layer stacked on first active material layer |
| Comparati ve Example 5 | 60 wt% of first particle | 20 wt% of first particle, 20 wt% of second particle | First active material layer stacked on second active material layer |

Thickness and pellet density (PD) of each of the positive electrode active materials of the prepared positive electrodes were measured, and the results are shown in Table 2.

**Table 2**

| Item | Thickness | | | | |
|---|---|---|---|---|---|
| | Form of positive electrode active material | Thicknes s of first active material | Thickness of second active material | Total thickness of active materials (µm) | Pellet densit y (g/cc) |
| Example 1 | Double layer | 45 | 5 | 50 | 2.64 |
| Example 2 | Double layer | 40 | 10 | 50 | 2.70 |
| Example 3 | Double layer | 35 | 15 | 50 | 2.76 |
| Example 4 | Double layer | 30 | 20 | 50 | 2.81 |
| Example 5 | Double layer | 25 | 25 | 50 | 2.87 |
| Comparati ve Example 1 | Single layer | 50 | 0 | 50 | 2.44 |
| Comparati ve Example 2 | Single layer | 0 | 50 | 50 | 3.57 |
| Comparati ve Example 3 | Single layer | - | - | 50 | 2.76 |
| Comparati ve Example 4 | Double layer | 40 | 10 | 50 | 2.76 |
| Comparati ve Example 5 | Double layer | 30 | 20 | 50 | 2.79 |

### Evaluation Example 3: Evaluation of Battery Properties

Properties of rechargeable lithium batteries prepared using the positive electrodes of Examples 1 to 5 and Comparative Examples 1 to 5 were evaluated.

For initial charging/discharging, the rechargeable lithium batteries were initially charged at a constant current of 0.1 C and a constant voltage of 4.2 V, and after 10 minutes of rest, discharged up to 3.0 V at a constant current of 0.1 C. Thereafter, the charging/discharging was repeated 50 times at 45 °C and 1.0 C/1.0 C. In addition, a coin cell was additionally prepared and measured at -20 °C for a capacity of 0.2 C. The results of evaluating the battery properties are shown in Table 3.

**Table 3**

| Item | Charge at 4.2 V (mAh/g ) | Dischar ge at 4.2 V (mAh/g) | Efficienc y at 4.2 V (%) | Lifetim e at 4.2 V (%, 50 cycles) | Capaci ty at - 20 °C (mAh/g ) | Energ y densit y (Wh/L ) | Averag e voltage (V) |
|---|---|---|---|---|---|---|---|
| Example 1 | 172.4 | 157.6 | 91.4 | 96.9 | 58.3 | 1340 | 3.22 |
| Example 2 | 175.6 | 159.7 | 90.9 | 96.8 | 61.5 | 1401 | 3.25 |
| Example 3 | 178.8 | 161.8 | 90.5 | 96.6 | 64.6 | 1460 | 3.27 |
| Example 4 | 183.1 | 164.8 | 90 | 96.5 | 67.8 | 1528 | 3.3 |
| Example 5 | 186.0 | 166.7 | 89.6 | 96.3 | 70.9 | 1588 | 3.32 |
| Comparati ve Example 1 | 164.1 | 155.3 | 94.6 | 97.1 | 53.2 | 1212 | 3.2 |
| Comparati ve Example 2 | 226.6 | 197.3 | 86.8 | 94.0 | 114.4 | 2599 | 3.69 |
| Comparati ve Example 3 | 181.0 | 162.9 | 90.0 | 96.5 | 65.4 | 1484 | 3.3 |
| Comparati ve Example 4 | 181.6 | 163.4 | 90.0 | 96.4 | 66.3 | 1488 | 3.3 |
| Comparati ve Example 5 | 182.9 | 164.5 | 89.9 | 96.3 | 65.4 | 1514 | 3.3 |

Referring to Table 3, it is determined that the rechargeable batteries according to Examples 1 to 5 of the present disclosure are significantly superior to the rechargeable battery according to Comparative Example 1 in energy density. In addition, it is determined that the rechargeable batteries according to Examples 1 to 5 are superior to the rechargeable battery according to Comparative Example 2 in cell efficiency and lifetime characteristics.

In addition, it is determined that the rechargeable battery according to Example 4 is superior to the rechargeable batteries according to Comparative Examples 3 and 4 in energy density and capacity at -20 °C (low-temperature characteristics). For example, it is determined that, in both (e.g., simultaneously) energy density and low-temperature characteristics, the positive electrode of Example 4, which has a double layer structure and includes both (e.g., simultaneously) the first particle and the second particle in an upper layer, is superior to the positive electrode of Comparative Example 3, which has a single layer structure and simply mixed first and second particles, and the positive electrode of Comparative Example 4, which has a double layer structure and includes the second particle alone in an upper layer.

In addition, it is determined that the rechargeable battery according to Example 4 is significantly superior to the rechargeable battery according to Comparative Example 5 in capacity at -20 °C (low-temperature characteristics). For example, it is determined that the positive electrode of Comparative Example 5, which has a double layer structure but includes the first particle and the second particle in a lower layer, has somewhat poorer low-temperature characteristics than Example 4.

A positive electrode according to the present disclosure has a double layer structure in which a second active material layer containing a mixture of an olivine-based particle and a layered particle is stacked on a first active material layer on the basis of an olivine-based particle and may thus have improved energy density and low-temperature properties.

A rechargeable battery including the positive electrode according to the present disclosure has excellent or suitable energy density and low-temperature properties.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the context of the present application and unless otherwise defined, the terms "use," "using," and "used" may be considered synonymous with the terms "utilize," "utilizing," and "utilized," respectively.

Further, the use of "may" when describing embodiments of the inventive concept refers to "one or more embodiments of the inventive concept."

As used herein, the singular forms "a", "an" and "the" are intended to include the plural forms as well, unless the context clearly indicates otherwise. I

A battery manufacturing device, a battery management system (BMS) device, and/or any other relevant devices or components according to embodiments of the present invention described herein may be implemented utilizing any suitable hardware, firmware (e.g. an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the present disclosure.

Although one or more embodiments of the present disclosure have been described with reference to the accompanying drawings, it is understood that the present disclosure should not be limited to these embodiments but one or more suitable changes and modifications can be made by one ordinary skilled in the art within the scope of the present disclosure as hereinafter claimed. Therefore, one or more embodiments described above should be understood in all respects as illustrative and not limiting.

## Claims

1. A positive electrode for a rechargeable lithium battery comprising:
a current collector;
a first active material layer on the current collector; and
a second active material layer on the first active material layer,
wherein the first active material layer and the second active material layer each comprise a first particle,
the second active material layer further comprises a second particle, and
the first particle comprises a compound represented by Formula 1, and the second particle comprises a compound represented by Formula 2:
Formula 1 Liₐ₁Feₓ₁B1_{y1}PO_{4-b1},
wherein in Formula 1, 0.8≤a1≤1.2, 0.95≤x1≤0.999, 0.001≤y1≤0.05, 0≤b1≤0.05, and x1 + y1 = 1 are satisfied, and
in Formula 1, B1 is at least one element selected from among the group consisting of Ti, Mg, V, and Al,
Formula 2 Liₐ₂Niₓ₂Co_{y2}Al_{z2}B2_{w2}O_{2-b2},
wherein in Formula 2, 0.8≤a2≤1.2, 0.8≤x2≤0.95, 0.02≤y2≤0.19, 0.001≤z2≤0.03 0≤w2≤0.1, 0≤b2≤0.05, and x2 + y2 + z2 + w2 = 1 are satisfied, and
in Formula 2, B2 is at least one element selected from among the group consisting of Ti, Mg, Zr, and Al.

2. The positive electrode for a rechargeable lithium battery as claimed in claim 1, wherein a content of the second particle is in a range of about 5 wt% to about 25 wt% with respect to a total content of the first particle and the second particle in the first active material layer and the second active material layer.

3. The positive electrode for a rechargeable lithium battery as claimed in claim 1 or claim 2, wherein a content of the second particle is in a range of about 40 wt% to about 60 wt% with respect to a total content of the first particle and the second particle in the second active material layer.

4. The positive electrode for a rechargeable lithium battery as claimed in any one of claims 1 to 3, wherein the second active material layer has a thickness of about 0.1 to about 0.5 with respect to a total thickness of the first active material layer and the second active material layer.

5. The positive electrode for a rechargeable lithium battery as claimed in any one of claims 1 to 4, wherein the second particle has an average particle diameter (D50) of about 8 µm to about 20 µm.

6. The positive electrode for a rechargeable lithium battery as claimed in any one of claims 1 to 5, wherein the second particle comprises a second secondary particle in the form of a secondary particle and a second single particle in the form of a single particle.

7. The positive electrode for a rechargeable lithium battery as claimed in any one of claim 6, wherein the second secondary particle has an average particle diameter (D50) of about 12 µm to about 16 µm.

8. The positive electrode for a rechargeable lithium battery as claimed in claim 6 or claim 7, wherein the second single particle has an average particle diameter (D50) of about 3 µm to about 5 µm.

9. The positive electrode for a rechargeable lithium battery as claimed in any one of claims 1 to 8, wherein,
the second particle comprises a second coating layer, and
the second coating layer comprises a boron-containing compound, an aluminium-containing compound, or a combination thereof.

10. The positive electrode for a rechargeable lithium battery as claimed in any one of claims 1 to 9, wherein,
the first active material layer further comprises a first binder and a first conductive material,
the second active material layer further comprises a second binder and a second conductive material, and
a content of the first binder is greater than a content of the second binder.

11. The positive electrode for a rechargeable lithium battery as claimed in any one of claims 1 to 10, wherein,
the first active material layer has a loading level of about 5 mg/cm² to about 10 mg/cm².

12. The positive electrode for a rechargeable lithium battery as claimed in any one of claims 1 to 11, wherein,
the second active material layer has a loading level of about 5 mg/cm² to about 25 mg/cm².

13. The positive electrode for a rechargeable lithium battery as claimed in any one of claims 1 to 12, wherein,
the first particle comprises at least one first primary particle,
the first primary particle has a particle diameter of about 200 nm to about 300 nm.

14. The positive electrode for a rechargeable lithium battery as claimed in any one of claims 1 to 13, wherein,
the first particle has an average particle diameter (D50) of about 0.5 µm to about 2.5 µm.

15. A rechargeable lithium battery comprising the positive electrode according to any one of claims 1 to 14.
